# EUROPÄISCHE PATENTSCHRIFT

(11) **EP 1 746 462 B1**
(45) Veröffentlichungstag und Bekanntmachung des Hinweises auf die Patenterteilung: **31.10.2012**
(21) Anmeldenummer: 06012465.8
(22) Anmeldetag: 17.06.2006
(51) Int. Cl.: G03F 7/20

(54) **Verfahren zur Belichtung von Flexodruckplatten**
Process for the exposure of flexographic printing plates
Procédé pour l'exposition de plaques d'impression flexographiques

(30) Priorität: 02.07.2005 DE 102005031057
(43) Veröffentlichungstag der Anmeldung: 24.01.2007
(73) Patentinhaber: Xeikon IP BV, 4529 GZ Eede (NL)
(72) Erfinder: Eggers, Stefan, 21465 Wentorf (DE)
(74) Vertreter: Knoop, Philipp

(56) Entgegenhaltungen:
- US-A1- 2004 177 782
- US-A1- 2005 011 382
- US-A1- 2005 266 358

## Beschreibung

Die vorliegende Erfindung betrifft ein Verfahren zur Erzeugung einer Struktur von Photopolymerisationsbildpunkten in der lichtempfindlichen Schicht von Druckplatten, insbesondere Flexodruckplatten, als Abbild von aus einer Matrix von Bildpunkten zusammengesetzten Bilddaten mittels strukturierter Belichtung mit einer Lichtquelle.

Derartige Verfahren finden Anwendung im Zusammenhang mit Hochdruckverfahren. Dabei sind die druckenden Elemente erhöht. Die Druckplatten sind mit einer Schicht lichtempfindlichen Materials versehen, auf welche das gattungsgemäße Verfahren zur Erzeugung der druckenden Elemente mittels Photopolymerisation angewendet wird. Die Belichtung erfolgt typischerweise durch UV-Belichtung. Bei der UV-Belichtung der Druckplatten werden chemische Bestandteile der Schicht polymerisiert, d. h. verkettet. Beim Belichtungsvorgang wirkt in der lichtempfindlichen Schicht vorhandener freier Sauerstoff dieser UVinduzierten Polymerisation entgegen. Der Sauerstoff muß daher für die Erzeugung von Bildpunkten durch die UV-Belichtung zunächst lokal gebunden werden, bevor die Polymerisation einsetzen kann. Diese Bindung ist ein reversibler Vorgang, der sich innerhalb von Minuten zurückbildet, sofern an dem betreffenden Punkt keine weitergehende Polymerisation erfolgt ist.

Aus diesen chemischen Begebenheiten ergeben sich einige Probleme bei der Belichtung der Druckplatten. Wenn nämlich schwach gedeckte Flächen, sogenannte "highlights", belichtet werden sollen, schwächt der nachdiffundierende Sauerstoff aus den unbelichteten Nachbarbereichen die Polymerisation des Bildpunktes. Dies führt dazu, dass sich die erforderliche Belichtungszeit zur Erzeugung des Photopolymerisationsbildpunktes verlängert. Im Extremfall besonders kleiner Rasterpunkte kann es insgesamt unmöglich werden, den Bildpunkt durch Polymerisation derart zu erzeugen, dass er mit der Druckplatte fest verbunden ist.

Vor diesem Hintergrund ist ein Belichtungsverfahren üblich geworden, bei welchem die Druckplatten zunächst einer unstrukturierten Vorbelichtung unterzogen werden und anschließend mit einem bestimmten Zeitverzug endbelichtet werden. Die unstrukturierte Vorbelichtung wird "prebump" bzw. "bump" genannt. Sie wird auf die gesamte Oberfläche der Druckplatte angewendet. Es hat sich gezeigt, dass bei Durchführung einer derartigen unstrukturierten Vorbelichtung die Erzeugung von Bildpunkten auch in Bereichen von nur schwach gedeckten Flächen ("highlights") teilweise erst ermöglicht wird.

Allerdings hat sich auf der anderen Seite gezeigt, dass in hochgedeckten Flächen, also Flächen mit großer Flächendichte von zu erzeugenden Polymerisationsbildpunkten - sogenannten "Shadows" -, die unstrukturierte Vorbelichtung dazu führt, dass kleine Löcher in der ansonsten fast vollständig geschlossenen Oberflächen in unerwünschter Weise ebenfalls polymerisieren. Dies wird damit erklärt, dass der ursprünglich in der lichtempfindlichen Schicht enthaltene ungebundene Sauerstoff benötigt wird, um die kleinen Löcher in der fast vollständig geschlossenen Oberfläche offenzuhalten. Somit ist die unstrukturierte Vorbelichtung für die Belichtung der hochdeckten Flächen (Shadows) kontraproduktiv.

In der Praxis wird daher nach der erfolgten unstrukturierten Vorbelichtung eine Zeit von typischerweise zwischen 20 und 60 Sekunden abgewartet, bis die eigentliche strukturierte Belichtung durchgeführt wird. Gemäß der Theorie bildet sich die reversibel eingegangene Bindung des freien Sauerstoffs innerhalb dieser Zeit wieder zu einem gewissen Grade zurück. Dieses neuerliche Freiwerden des Sauerstoffs ist für die hochgedeckten Flächen wie erläutert von Vorteil bzw. erforderlich, gleichzeitig jedoch für die Erzeugung der schwach gedeckten Flächen von Nachteil.

Bei den bekannten und üblichen Verfahren der unstrukturierten Vorbelichtung gilt es daher, durch Wahl einer geeigneten Abwartezeit dahingehend einen Kompromiss zu finden, dass die Konzentration des freien Sauerstoffs einerseits wieder hoch genug wird, um kleine Löcher in der fast vollständig gedeckten Fläche offen halten zu können, und andererseits die Konzentration des wieder entstehenden freien Sauerstoffs nicht durch zu langes Abwarten so hoch ansteigen zu lassen, dass die vollständige Polymerisation von Polymerisationsbildpunkten in den schwach gedeckten Flächen nicht mehr möglich ist. Dieser gemäß den bekannten Verfahren eingegangene Kompromiss führt dazu, dass die Belichtungsverhältnisse sowohl in den hochgedeckten Flächen als auch an den nur schwach gedeckten Flächen suboptimal sind. Der Tonwertumfang einer Flexoplatte ist aufgrund dessen in der Regel auf ca. 10 % bis 90 % begrenzt.

Da die erforderlichen Belichtungszeiten für shadows und highlights um einen Faktor 10 bis 100 unterschiedlich sein können, wird bei der Belichtung nach dem beschriebenen herkömmlichen Verfahren zwangsläufig eine 10- bis 100-fache Überbelichtung der shadows vorgenommen. Dies führt jedoch nachteilig dazu, daß kleine Löcher in fast vollständig gedeckten Flächen zusammenwachsen.

Zudem ist die Wartezeit zwischen unstrukturierter Vorbelichtung und der eigentlichen strukturierten Belichtung nachteilig für die Bearbeitungszeit zur Belichtung der Druckplatten, wenn eine digitale Belichtung oder eine Direktbelichtung verwendet wird. Insbesondere wenn Optimierungsalgorithmen zur Auslassung nicht belichteter Bildbereiche zum Einsatz kommen, stellt eine konstante Zeitdifferenz zwischen Vorbelichtung und strukturierter Belichtung ein erhebliches Problem in der Ablaufsteuerung dar.

In der US 2002/0058196 A1 ist vor diesem Hintergrund ein Verfahren beschrieben, bei dem die unstrukturierte Vorbelichtung lediglich auf die nicht-gedeckten Bildbereiche, an denen also keine Photopolymerisationsbildpunkte erzeugt werden sollen, angewendet wird. Im Ergebnis wird also bei der Vorbelichtung das invertierte Bild (das - Negativ) belichtet. Ziel dieses vorbekannten Verfahrens ist eine deutliche Reduzierung oder Eliminierung der bei den üblichen Verfahren -notwendigen Wartezeit zwischen Vorbelichtung und eigentlicher Belichtung und eine Verbesserung der Druckqualität. Bei dem bekannten Verfahren erfolgt also die Vorbelichtung nicht in unstrukturierter Weise sondern in Abhängigkeit von dem zu erzeugenden Bild als dessen Invertierung. Erste Versuche haben jedoch gezeigt, daß mit diesem Verfahren in der Praxis jedoch lediglich durchmischte Ergebnisse gezeigt. Insbesondere ein "Zuwachsen" von Löchern in Shadow-Bereichen konnte im Einzelfall nicht vermieden werden. Systematische Ergebnisse liegen noch nicht vor.

Der vorliegenden Erfindung liegt daher die Aufgabe zugrunde, ein Verfahren zur Erzeugung einer Struktur von Photopolymerisationsbildpunkten in der lichtempfindlichen Schicht von Druckplatten der eingangs genannten Art dahingehend zu verbessern, dass ein besserer Tonwertumfang des Druckbildes erreicht wird und gleichzeitig die Herstellungszeit reduziert wird.

Diese Aufgabe wird gemäß der vorliegenden Erfindung dadurch gelöst, dass jeder Photopolymerisationsbildpunkt durch eine individuelle, in Abhängigkeit von der Flächendichte der zu setzenden Photopolymerisationsbildpunkte am Ort des Photopolymerisationsbildpunktes einerseits und von den Bilddaten andererseits gewählte Belichtungssequenz erzeugt wird, wobei an nicht gesetzten Bildpunkten, welche sich an Orten mit mittlerer Flächendichte befinden, nicht-druckende Photopolymerisationsuntergrundpunkte mit einer Vorbelichtungssequenz erzeugt werden(*bump*), umfassend den folgenden Schritt:
a. Belichten mit einer Vorbelichtungsdosis zum Binden des in der lichtempfindlichen Schicht enthaltenen Sauerstoffs, wobei die Vorbelichtungsdosis so gewählt ist, daß noch keine Photopolymerisation erfolgt
und wobei an gesetzten Bildpunkten unabhängig von der Flächendichte druckende Photopolymerisationsbildpunkte mit einer Standardsequenz erzeugt werden(*main*), umfassend die Schritte
a. Belichten mit der genannten Vorbelichtungsdosis
b. Belichten mit einer Strukturverstärkungsdosis, wobei die Strukturverstärkungsdosis so gewählt ist, daß sie zusammen mit der Vorbelichtungsdosis einen Zustand erzeugt, in welchem die Druckschicht im wesentlichen nicht mehr vollständig abentwickelbar ist.
c. Belichten mit einer Standarddosis, wobei die Standarddosis so gewählt ist, daß sie zusammen mit der Vorbelichtungsdosis und der Strukturverstärkungsdosis an Orten mit größter Flächendichte eine vollständige Photopolymerisation des Photopolymerisationsbildpunktes bewirkt.
und wobei an nicht gesetzten Bildpunkten, welche sich an Orten mit großer Flächendichte befinden, keine Belichtung erfolgt.

Flächendichte der zu setzenden Photopolymerisationsbildpunkte bedeutet im Rahmen der vorliegenden Anmeldung das Verhältnis der Anzahl der gemäß den in der Matrix enthaltenen Bilddaten zu setzenden Bildpunkte in einem Flächenelement in Relation zu der Gesamtanzahl der Bildpunkte, die sich aus der Summe der gesetzten und der ungesetzten Bildpunkte ergibt, welche in diesem Flächenelement enthalten sind. Die Ausdehnung des zweckmäßigerweise zu betrachtenden Flächenelements hängt ab von der Divergenz der Lichtquelle und von der Schichtdicke, dem Schichtaufbau sowie dem Material der Druckplatte. In der Praxis wird man sich häufig aufgrund des Verhältnisses der Pixelgröße zu den genannten Einflußgrößen auf die Betrachtung der zwei nächsten Nachbarn beschränken.

Der Vorteil des erfindungsgemäßen Verfahrens gegenüber den bekannten Verfahren ist, dass die Belichtungssequenz eines jeden Photopolymerisationsbildpunktes nicht nur von der Bildinformation für diesen Punkt selber abhängt, sondern dass vielmehr darüber hinaus durch Bestimmung der Flächendichte auch die Umgebung des zu erzeugenden Photopolymerisationsbildpunktes mit berücksichtigt wird. In Bereichen hochgedeckter Flächen, also Bereichen mit großer Flächendichte erfolgt erfindungsgemäß keine Vorbelichtung. Dies führt mit Vorteil dazu, dass aufgrund der oben beschriebenen chemischen Vorgänge das Offenhalten von kleinen Löchern in einer ansonsten fast vollständig geschlossenen Oberfläche besser möglich ist.

Gleichzeitig ist jedoch mit Vorteil durch die erfindungsgemäße Auswahl der Belichtungssequenz in Abhängigkeit von der Flächendichte die Möglichkeit gegeben, an Orten mit besonders kleiner Flächendichte, also im Bereich von nur schwach gedeckten Flächen ("highlights"), eine Vorbelichtung durchzuführen, um den in der lichtempfindlichen Schicht enthaltenen Sauerstoff zu binden. Hierdurch wird mit Vorteil verhindert, dass durch den freien Sauerstoff die Belichtungszeit zur Erzeugung der druckenden Photopolymerisationsbildpunkte verlängert.

Wohingegen bei den bekannten Belichtungsverfahren ein Kompromiss eingegangen werden muss, der dazu führt, dass die Belichtungsverhältnisse weder für die stark gedeckten Shadow-Bereiche noch für die schwach gedeckten Highlight-Bereiche optimal sind, ermöglicht die erfindungsgemäße Auswahl der Belichtungssequenz in Abhängigkeit von der Flächendichte der zu setzenden Photopolymerisationsbildpunkte mit Vorteil die Bereitstellung einer jeweils optimalen Belichtungssequenz für jeden zu setzenden und nicht zu setzenden Bildpunkt. Insbesondere entfällt vorteilhaft eine Wartezeit zwischen Vorbelichtung und der eigentlichen Belichtung vollständig.

Zwischen den erfindungsgemäß vorgesehenen Schritten der Belichtungssequenz ist mit Vorteil keine Wartezeit vorgesehen. Die Dosen werden unmittelbar aufeinanderfolgend aufgebracht, so daß sie sich innerhalb jeder Belichtungssequenz zu einer Gesamtdosis addieren.

Dadurch, dass jeder Pixel der Druckplatte mit einer individuellen, in Abhängigkeit von der Flächendichte der zu setzenden Photopolymerisationsbildpunkte in der Umgebung des Photopolymerisationsbildpunktes gewählten Belichtungssequenz belichtet wird, entfallen mit Vorteil die unerwünschten Wartezeiten. Die sich ohne Zeitverzug unmittelbar aneinander anschließenden Schritte gemäß der erfindungsgemäßen Standardsequenz führen im Ergebnis zu einer Belichtung des Photopolymerisationsbildpunktes an Orten mit größter Flächendichte (shadows) mit einer Gesamtbelichtungsdosis. Die Gesamtbelichtungsdosis ist durch die Summe aus der Vorbelichtungsdosis, der Strukturverstärkungsdosis sowie der Standarddosis gegeben. Sie entspricht der Belichtungsdosis, welche erforderlich ist, um einen Photopolymerisationsbildpunkt in einem hochgedeckten Bereich (Shadow) durch Polymerisation derart zu erzeugen, dass er am Untergrund der Druckplatte haftet.

Die Berücksichtigung der Flächendichte gemäß der vorliegenden Erfindung ermöglicht auf diese Weise eine deutliche Verbesserung des. Tonwertumfangs des fertigen Druckbildes, wobei gleichzeitig die Gesamtbelichtungszeit für die Druckplatte durch den Wegfall der Wartezeit drastisch reduziert wird.

Die Belichtungssequenz für einen gegebenen Punkt auf der Druckplatte hängt somit gemäß der Erfindung einerseits naturgemäß davon ab, ob dieser Punkt ein Bildpunkt ist oder nicht, ob er also gesetzt wird oder nicht. Insoweit entspricht das erfindungsgemäße Verfahren den vorbekannten Standardverfahren zur Erzeugung einer Struktur von Photopolymerisationsbildpunkten. Bei dem erfindungsgemäßen Verfahren hängt die Belichtungssequenz jedoch darüber hinaus auch noch von der Flächendichte, also von der Umgebung des Punktes, sowohl der zu setzenden Photopolymerisationsbildpunkte als auch der nicht gesetzten Untergrundpunkte ab. Hierin unterscheidet sich das erfindungsgemäße Verfahren von den vorbekannten Verfahren.

Gemäß dem erfindungsgemäßen Verfahren werden also bezüglich der Wahl der Belichtungssequenz die folgenden Fälle unterschiedlich behandelt:
(1) Nichtdruckender Bildpunkt in einem Bereich mittlerer Flächendichte
(2) Nichtgesetzter Bildpunkt an einem Ort mit großer Flächendichte
(3) Gesetzter Bildpunkt an Orten mit mittlerer oder großer Flächendichte.

Im Falle 1 wird individuell für den jeweiligen Bildpunkt eine Vorbelichtung durchführt, im Falle 2 wird keine Vorbelichtung durchgeführt, da diese wie oben erläutert kontraproduktiv wäre, im Falle 3 wird der druckende Photopolymerisationsbildpunkt erzeugt.

Das Verfahren gemäß der vorliegenden Erfindung wird noch verbessert, wenn zusätzlich an nichtgesetzten Bildpunkten in einer Umgebung von Photopolymerisationsbildpunkten, welche sich an Orten mit kleiner Flächendichte befinden, mittels einer Strukturverstärkungssequenz nicht druckende Strukturverstärkungspunkte erzeugt werden, wobei die Strukturverstärkungssequenz die folgenden Schritte umfasst:
a) Belichten mit der Vorbelichtungsdosis
b) Belichten mit der Strukturverstärkungsdosis.

Es wird also in schwach gedeckten Flächenbereichen, den sogenannten Highlights, in denen sich zum Teil einzeln stehende Polymerisationsbildpunkte befinden, eine nicht druckende Teilschicht rund um den zu druckenden Pixel aufgebaut. Hierdurch wird mit Vorteil die mechanische Resistenz des Pixels sowohl im Entwicklungs- als auch im Druckprozess unterstützt. In einer schwach gedeckten Umgebung, also einer Umgebung mit kleiner Flächendichte, um einzeln stehende Pixel herum wird gleichsam ein unterstützender Sockel aufgebaut. Dieser Sockel ist jedoch aufgrund seiner im Vergleich zu einem druckenden Pixel geringeren Höhe nicht druckend. Der Sockel beeinflußt somit nicht das Druckbild. Die Divergenz der Lichtquelle führt hier zu einer Ortsabhängigkeit der Lichtintensität, so daß beispielsweise in tieferen Schichten eine andere Intensität wirkt als in höheren Schichten der Druckplatte.

Durch die Strukturverstärkungssequenz wird gemäß der Erfindung mit einer Gesamtdosis an UV-Licht belichtet, welche sich aus der Summe aus Vorbelichtungsdosis und Strukturverstärkungsdosis ergibt. Hierdurch wird ein Zustand auf der Oberfläche der Druckplatte erreicht, bei welchem die lichtempfindliche Schicht nicht mehr vollständig wasserlöslich ist, wie dies im unbelichteten Zustand der lichtempfindlichen Schicht der Fall ist.

Bei der Entwicklung der Druckplatte nach Abschluss des Belichtungsvorgangs werden Pixel auf der Druckplattenoberfläche, welche in diesen Zustand versetzt worden sind, daher nicht mehr vollständig ausgewaschen. Der durch die Strukturverstärkungssequenz hervorgerufene Zustand unterscheidet sich von dem vollständig polymerisierten Zustand eines Pixels, wie er durch die Standardsequenz erzeugt wird, jedoch dadurch, dass der Pixel noch nicht vollständig am Untergrund der Druckplatte anhaftet. Dadurch entsteht eine unregelmäßige, klebrige Struktur an der Oberfläche der Druckplatte, welche einerseits nichtdruckend ist, um das Bild nicht zu verfälschen, welche andererseits jedoch zur Erhöhung der mechanischen Resistenz des von den Strukturverstärkungspunkten umgebenen Photopolymerisätionsbildpunktes beiträgt.

Zusätzlich hat der Aufbau von Strukturverstärkungspunkten gemäß der Erfindung den Vorteil, dass durch die zusätzlich eingebrachte Belichtungsdosis das sogenannte Bonding des Pixels an das Druckplattenträgermaterial schneller erreicht wird. Die Strukturverstärkungspunkte wirken insofern wie eine Art klebender Kitt, mit welchem ein einzeln stehender Bildpunkt mit dem Druckplattenträgermaterial verbunden wird.

Der beschriebene Zustand, in den die Strukturverstärkungssequenz die Strukturverstärkungspunkte versetzt, ist durch einen sehr eng umrissenen Belichtungsdosisbereich definiert. Die auf die Vorbelichtungsdosis aufzuschlagende Strukturverstärkungsdosis ist daher verhältnismäßig klein. Sie entspricht einem Zwischenzustand zwischen der bloßen Vorbelichtung, welche gemäß der Theorie zum Binden des freien Sauerstoffs der lichtempfindlichen Schicht dient, und der durch die Standardsequenz aufgebrachten Dosis, welche zu einer vollständigen Polymerisation des Photopolymerisationsbildpunktes führt.

Ein weiterer Vorteil des erfindungsgemäßen Verfahrens und des erfindungsgemäßen Erzeugens von Strukturverstärkungspunkten in einer Umgebung einzeln stehender Photopolymerisationsbildpunkte ist, dass in dem Strukturverstärkungspunkt der freie Sauerstoff ebenfalls wie schon beim Vorbelichten gebunden ist, so dass die Erzeugung des frei stehenden Bildpunktes im Highlight Bereich, also im Bereich sehr kleiner Flächendichte, deutlich erleichtert wird.

Gemäß einer vorteilhaften Ausführungsform des erfindungsgemäßen Verfahrens ist die Umgebung quadratisch gewählt. Hierdurch werden die genannten Vorteile der Strukturverstärkungspunkte besonders effektiv ausgenutzt, da symmetrische Verhältnisse vorliegen, so dass eine mechanische Verstärkung des Bildpunktes gleichermaßen in allen Richtungen erzielt wird.

Noch vorteilhafter ist es nach einer anderen Ausgestaltung des erfindungsgemäßen Verfahrens, wenn die Ausdehnung der Umgebung in Abhängigkeit von der Divergenz der Lichtquelle gewählt wird. Hierdurch wird mit Vorteil stets eine optimale Ausdehnung der Umgebung für die Strukturverstärkungspunkte erreicht. Je divergenter die Lichtquelle, desto geringer ist die Strahlungsenergie, welche auf den Bereich innerhalb der Schicht unter halb eines allein stehenden Pixels, also einen Bildpunkt innerhalb eines Bereich mit sehr kleiner Flächendichte (Highlight), auftrifft. Dies führt dazu, dass mit steigender Divergenz der Lichtquelle eine immer geringere Haftung der lichtempfindlichen Schicht am Trägermaterial der Druckplatte erfolgt. Bei einer Vollfläche würden sich die geringeren Intensitäten der einzelnen Pixel an der Materialunterseite wieder zu der Gesamtintensität an der Oberfläche überlagern. Dies ist jedoch im Falle von allein stehenden Bildpunkten, also Highlights, nicht möglich. Im Ergebnis ist daher der Bedarf an Strukturverstärkungspunkten umso größer, je größer die Divergenz der Lichtquelle ist.

Das erfindungsgemäße Verfahren wird noch weiter verbessert, wenn die Ausdehnung der Umgebung in Abhängigkeit von der Schichtdicke des Druckmaterials auf der Druckplatte gewählt wird. Auch diese Maßnahme hat den Vorteil, dass eine bedarfsgerechte Stabilisierung einzeln stehender Bildpunkte erreicht wird. Die mechanische Stabilität von Photopolymerisationsbildpunkten auf dem Trägermaterial wird umso geringer, je größer die Dicke der lichtempfindlichen Schicht auf der Druckplatte ist, da bei gleicher Pixel*fläche* die Pixelhöhe desto größer wird. Das Verhältnis zwischen Pixelfläche zu Pixelhöhe verkleinert sich also mit steigender Schichtdicke. Hieraus ergibt sich, dass die Ausdehnung der Umgebung, innerhalb derer Strukturverstärkungspunkte erzeugt werden sollten, umso größer sein sollte, je dicker die lichtempfindliche Schicht gewählt ist.

Besonders günstig hat sich erwiesen, wenn in Ausgestaltung des erfindungsgemäßen Verfahrens die Ausdehnung der Umgebung dem Produkt aus der Schichtdicke und dem Quotienten aus dem Tangens eines Aperturwinkels α einer Beleuchtungsoptik und der Pixelgröße entspricht.

Gemäß einer Variante des erfindungsgemäßem Verfahrens ist vorgesehen, dass an gesetzten Bildpunkten an Orten mit kleiner Flächendichte druckende Photopolymerisationsbildpunkte (*highlights*) mit einer Einzelbildpunktsequenz erzeugt werden, umfassend die Schritte:
a) Belichten mit der Vorbelichtungsdosis
b) Belichten mit der Strukturverstärkungsdosis
c) Belichten mit der Standarddosis
d) Belichten mit einer Einzelbildpunktdosis, wobei die Einzelbildpunktdosis so gewählt ist, dass sie zusammen mit der Vorbelichtungsdosis, der Strukturverstärkungsdosis und der Standarddosis eine vollständige Polymerisation der Photopolymerisationsbildpunkte an Orten mit kleinster Flächendichte bewirkt.

Hierdurch kann dem aus der Praxis bekannten und durch die Theorie untermauerten Phänomen Rechnung getragen werden, dass zur vollständigen Aushärtung von highlights, also von Bildpunkten in Bereichen mit sehr niedriger Flächendichte deutlich mehr Belichtungszeit benötigt wird, als zum Aushärten von Bildpunkten in Bereichen mit großer Flächendichte. In der Praxis können sich die erforderlichen Belichtungszeiten um den Faktor 10 bis 100 unterscheiden. Das erfindungsgemäße Verfahren ermöglicht durch die individuelle Wahl der Belichtungssequenz für jeden Punkt, diese große Varianz der jeweils optimalen Belichtungsdosen für jeden Pixel gesondert sicherzustellen. Es wird also gemäß dieser Variante mit Vorteil erreicht, dass auch gesetzte Bildpunkte an Orten mit kleiner Flächendichte als vollständig polymerisierte und mit dem Trägermaterial der Druckplatte fest verbundene Photopolymerisationsbildpunkte erzeugt werden, ohne die Qualität des shadows zu beeinflussen. Der Faktor, um den sich die für die unterschiedlichen Pixel erforderlichen Belichtungszeiten unterscheiden, kann bis auf etwa den Faktor 2 reduziert werden.

In spezieller Ausgestaltung des erfindungsgemäßen Verfahrens ist vorgesehen, dass die Belichtung mittels eines Integrating-Digital-Screen-Imaging Verfahren (IDSI) durchgeführt wird, bei welchem Licht aus der Lichtquelle auf einem Lichtmodulator, der eine Mehrzahl von Reihen aus lichtmodulierenden Zellen aufweist, abgebildet wird und von diesem moduliert wird, wonach der Lichtmodulator auf die Druckplatte, welche sich in einer Relativbewegung zum Lichtmodulator befindet, abgebildet wird, wobei die Richtung der Bewegung im wesentlichen parallel zu der Richtung der Zeilen aus lichtmodulierenden Zellen verläuft und wobei die Bilddaten durch die Spalten des Lichtmodulators gescrollt werden, mit einer Rate, durch die die Abbildung der Bilddaten im wesentlichen stationär relativ zu der Druckplatte während der Bewegung gehalten wird, wobei der Scrollvorgang in Abhängigkeit von der für den jeweiligen Photopolymerisationsbildpunkt auf der Druckplatte vorgesehenen Belichtungssequenz nach einer bestimmten einstellbaren Anzahl der für die Belichtung der Druckplatte genutzten Zellen des Lichtmodulators unterbunden wird. Beim an sich bekannten Integrating-Digital-Screen-Imaging Verfahren wird der Bildinhalt in einer der Bewegung des Belichtungskopfes entgegen gesetzten Richtung synchron mit der Kopfgeschwindigkeit durch das Display geschoben. Dabei stehen bei einer beispielhaften gängigen Ausführung des Displays beispielsweise bis zu 768 Zeilen zur Verfügung, durch welche eine Bildinformation geschoben werden kann. Es lässt sich nun für jede Spalte gesondert wählen, durch wie viele Zeilen des Displays die enthaltene Bildinformation geschoben wird. Je größer die Anzahl der Zeilen, durch die die Bildinformation geschoben wird, umso länger die Belichtungszeit, dementsprechend umso größer die Belichtungsdosis. Das Digital-Screenlmaging Verfahren ist daher besonders gut geeignet, um das erfindungsgemäße Belichtungsverfahren mit individuellen Belichtungssequenzen für jeden Pixel durchzuführen. Als Lichtmodulator eignen sich die bekannten Lichtmodulatoren, insbesondere Mikrospiegelanordnung (DMD), LCD Matrix oder z. B. reflektierende Flüssigkristallmatrixen (LCOS). Auch magnetooptische Zellen oder ferroelektrische Zellen sind prinzipiell geeignet.

Der Einsatz des Integrating-Digital-Screen-Imaging Verfahrens wird in Weiterbildung des erfindungsgemäßen Verfahrens noch verbessert, wenn die Bilddaten in eine beliebige Spalte verschoben werden können, um von dort aus zu den nächsten folgenden Spalten übertragen zu werden.

Gemäß einer speziellen besonders vorteilhaften Ausgestaltung des erfindungsgemäßen Verfahrens wird der Lichtmodulator in vier jeweils aus einer wählbaren Anzahl von Spalten bestehende, bezüglich der ScrollRichtung hintereinander angeordnete Segmente, welche jeweils einer bestimmten Belichtungsdosis entsprechen, aufgeteilt. Auf diese Weise wird mit Vorteil jeder der o. g. Einzeldosen, also Vorbelichtungsdosis, Strukturverstärkungsdosis, Standarddosis und Einzelbildpunktdosis, ein Segment auf dem Lichtmodulator zugeordnet. Zweckmäßigerweise wird die Anzahl der Spalten entsprechend der benötigten Dosis gewählt. Dabei gilt, je größer die Anzahl der Spalten, desto länger die Belichtungszeit, und dementsprechend desto größer die Belichtungsdosis.

Dementsprechend ist besonders vorteilhaft in Ausgestaltung des erfindungsgemäßen Verfahrens vorgesehen, dass die Anzahl der Spalten der Segmente sich untereinander wie die Beträge der Belichtungsdosen verhalten. Dies ist besonders bei homogener Ausleuchtung des Lichtmodulators von Vorteil, da die Belichtungsdosis in diesem Fall ausschließlich von der Spaltenzahl bestimmt ist.

Die Erfindung wird noch verbessert, wenn die Anzahl der Spalten der Segmente unter Berücksichtigung einer der jeweiligen Spalte entsprechenden, ortsabhängigen Ausleuchtungsintensität des Lichtmodulators gewählt wird. Hierdurch kann mit Vorteil eine möglicherweise inhomogene Ausleuchtung des Lichtmodulators berücksichtigt werden, welche durch Inhomogenitäten in der Lichtquelle selber und/oder durch die Beleuchtungsoptik oder durch andere Faktoren verursachte Inhomogenitäten bedingt ist.

Zur Ermittlung der zu setzenden Photopolymerisationsbildpunkte an Orten mit kleinster Flächendichte ist in Weiterbildung des erfindungsgemäßen Verfahrens vorgesehen, dass ausgehend von dem Originalbild die folgenden Schritte mit dem jeweils im vorhergehenden Schritt erhaltenen Bild durchgeführt werden:
a) Eliminieren aller Pixel, die mindestens einen nicht gesetzten Nachbarn haben, vorzugsweise umfassend eine logische UND-Verknüpfung,
b) Setzen aller Pixel, die mindestens einen gesetzten Nachbarn aufweisen, vorzugsweise umfassend eine logische ODER-Verknüpfung,
c) Setzen der Pixel, die in dem durch Schritt b erhaltenen Bild nicht gesetzt sind und gleichzeitig im Ausgarigsbild gesetzt sind, vorzugsweise umfassend eine logische UND- sowie eine logische NICHT-Verknüpfung.

Der Vorteil dieses Verfahrens zur Ermittlung der highlight-Punkte, also einzeln zu setzender Bildpunkte in Bereichen kleiner Flächendichte, ist, dass ausschließlich einfache logische Verknüpfungen verwendet werden. Insbesondere werden keine extrem zeitaufwendigen Entrasterungen der Bilddaten zur Bestimmung der Flächendichte benötigt. Auch müssen keine Schleifen über Zeilen und Spalten gebildet werden, wo bitweise abgefragt wird, wie die Umgebung des jeweiligen Pixels gestaltet ist. Außerdem sind mit Vorteil keine Verzweigungen im Programmablauf aufgrund von Abfragen erforderlich.

Das erfindungsgemäße Verfahren zur Bestimmung der highlight-Bereiche hat sich in der Praxis als mehr als 100 mal so schnell wie die genannten herkömmlichen Verfahren erwiesen. Das erfindungsgemäße Verfahren kann je nach Materialstärke der lichtempfindlichen Schicht auf der Druckplatte so angepasst werden, dass der als highlight zu erkennende Pixelradius durch mehrfache Anwendung gesteigert wird. Wie weiter oben ausgeführt, kann es bei besonders starken lichtempfindlichen Schichten bereits bei einer kleinen Gruppe von allein stehenden Bildpunkten erforderlich sein, eine Belichtung gemäß der Einzelbildpunktsequenz durchzuführen und nicht lediglich bei völlig einzeln stehenden Bildpunkten.

Eine andere Variante des erfindungsgemäßen Verfahrens sieht zur Ermittlung der Pixel, welche mit der Strukturverstärkungssequenz behandelt werden sollen, vor, dass die Umgebung von Photopolymerisationsbildpunkten an Orten mit kleinster Flächendichte, wie folgt aus den Bilddaten ermittelt wird:
a. Setzen von Pixeln, die mindestens einen benachbarten Polymerisationsbildpunkt an einem Ort mit kleinster Flächendichte aufweisen, vorzugsweise umfassend eine ODER-Verknüpfung.

Der Vorteil ist, dass auf diese Weise die Orte, an denen Strukturverstärkungspunkte erzeugt werden sollen, aufgrund des Einsatzes von einfachen logischen Operatoren in kürzester Rechenzeit bestimmt werden können. Dies hat den Vorteil, dass die Belichtung schnell und effizient durchgeführt werden kann.

Eine Weiterbildung des erfindungsgemäßen Verfahrens sieht vor, dass die Ermittlung der Pixel, welche mit der Vorbelichtungssequenz behandelt werden sollen, mit folgendem Verfahren erfolgt, wobei ausgehend von dem Originalbild die folgenden Schritte mit dem jeweils im vorhergehenden Schritt erhaltenen Bild durchgeführt werden:
a) Setzen aller Pixel, die mindestens einen gesetzten Nachbarn haben, vorzugsweise umfassend eine logische ODER-Verknüpfung
b) Löschen aller Pixel, die mindestens einen nicht-gesetzten Nachbarn haben
c) Setzen aller Pixel, die Teil des in Schritt b erhaltenen Bildes, nicht aber Teil des Ausgangsbildes sind
d) Invertieren des in Schritt c erhaltenen Bildes.

Um bei bestimmten Mustern, wie beispielsweise bei 2 x 2 Schachbrettmustern, eine eindeutige Unterscheidung zwischen Pixeln, welche mit der Vorbelichtungssequenz behandelt werden sollen, und solchen Pixeln, die mit einer Strukturverstärkungssequenz behandelt werden sollen, zu erzielen, ist nach einer Variante des erfindungsgemäßen Verfahrens vorgesehen, dass zum Ermitteln von nichtdruckenden Photopolymerisationsuntergrundpunkten das in Schritt d) aus Anspruch 15 erhaltene Bild mit dem in Anspruch 14 erhaltenen Bild durch eine logische ODER-Operation verknüpft wird. Hierdurch werden im Zweifel die Pixel gemäß der Strukturverstärkungssequenz behandelt, was zu einer Priorisierung der Strukturverstärkung für einzeln stehende Pixel, also highlights, vorteilhaft ist.

Wenn hingegen die Offenhaltung von nichtdruckenden Bildpunkten innerhalb von Bereichen mit großer Flächendichte, also Löchern in Shadows, der Vorzug gegeben werden soll, sieht eine Variante des erfindungsgemäßen Verfahrens vor, dass zum Ermitteln von nichtdruckenden Photopolymerisationsuntergrundpunkten das in Schritt d) aus Anspruch 15 erhaltenen Bild mit dem in Anspruch 14 erhaltenen Bild durch eine logische UND-Operation verknüpft wird. Hierdurch wird erreicht, dass in Fällen wie beispielsweise von 2 x 2 Schachbrettmustern, -in denen eine Zuordnung sowohl für den Fall von keiner Belichtung als auch zu der Strukturverstärkungsbelichtung möglich ist, der Vorzug der Nicht-Belichtung gegeben wird. Dies hat zur Folge, dass vorteilhaft die Offenhaltung nicht gesetzter Bildpunkte, welche von gesetzten Bildpunkten umrandet sind, bevorzugt wird.

Eine Beschleunigung des gesamten Belichtungsvorgangs lässt sich bei einer weiteren Weiterbildung des erfindungsgemäßen Verfahrens erzielen, in dem an nicht gesetzten Bildpunkten an Orten mit verschwindender Flächendichte keine Belichtung erfolgt. Diese Bereiche können dann von dem Belichtungsvorgang komplett ausgespart werden. Bei den herkömmlichen Verfahren, bei denen eine unstrukturierte Vorbelichtung erfolgt, werden demgegenüber auch diese Punkte vorbelichtet, wobei die durch die Vorbelichtung erhaltene Wirkung der reversiblen Bindung von Sauerstoff sich nach einer gewissen Zeit ohnehin umkehren würde. Es ist daher vorteilhaft für die zeitliche Optimierung des Belichtungsvorgangs, wenn gemäß dem erfindungsgemäßen Verfahren diese Bereiche von vornherein nicht belichtet werden.

Die Erfindung wird in einer bevorzugten Ausführungsform unter Bezugnahme auf eine Zeichnung beispielhaft beschrieben, wobei weitere vorteilhafte Einzelheiten den Figuren der Zeichnung zu entnehmen sind.

Funktionsmäßig gleiche Teile sind dabei mit denselben Bezugszeichen versehen.

Die Figuren der Zeichnung zeigen im Einzelnen:
- Fig. 1:: Querschnitt durch eine zu belichtende Druckplatte mit schematischer Darstellung von Belichtungsverfahren gemäß dem Stand der Technik
- Fig. 2:: Die Darstellung aus Fig. 1 für ein anderes bekanntes Belichtungsverfahren
- Fig. 3:: Die Darstellung aus Fig. 1 für das Verfahren gemäß der vorliegenden Erfindung
- Fig. 4b:: Draufsicht auf einen allein stehenden highlight-Pixel mit der erfindungsgemäßen Strukturverstärkung

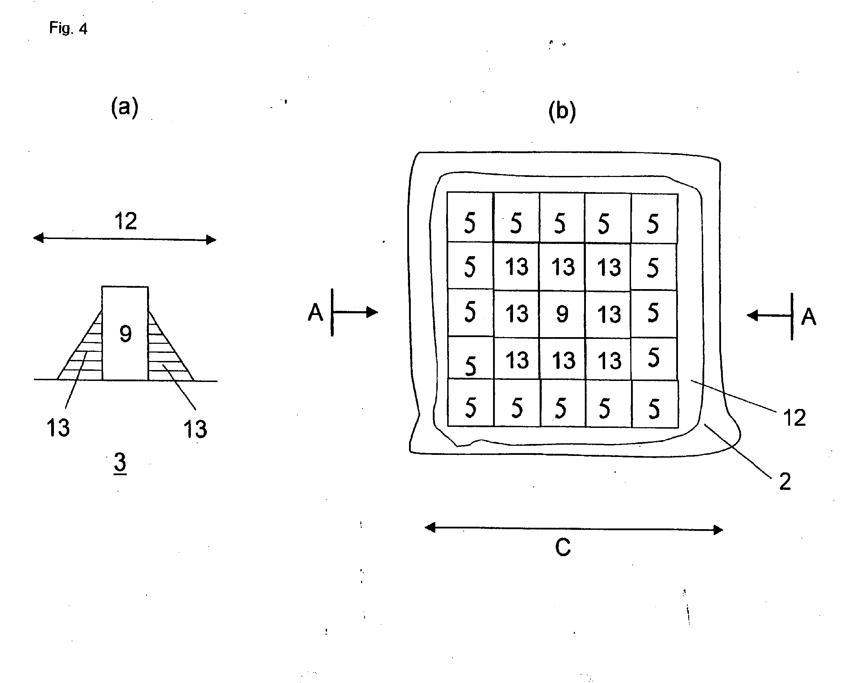

- Fig. 4a:: Schnitt entlang der Linie A-A in Fig. 4b

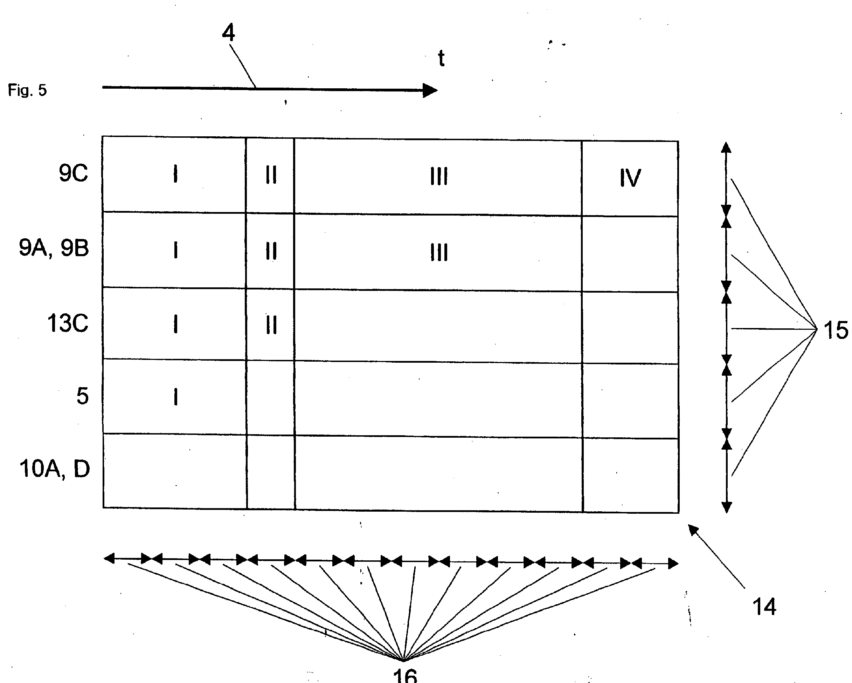

- Fig. 5:: schematische Darstellung der Segmente auf einem zur Durchführung des erfindungsgemäßen Verfahrens verwendeten Display

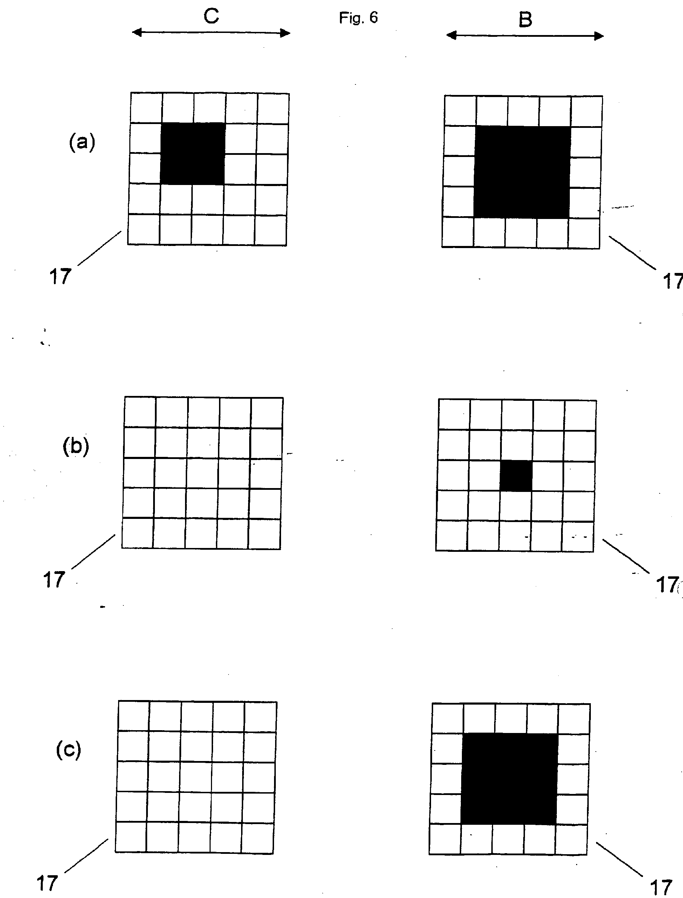

- Fig. 6:: schematische Veranschaulichung des Verfahrens zur Ermittlung einzeln stehender Pixel (highlight) gemäß der Erfindung

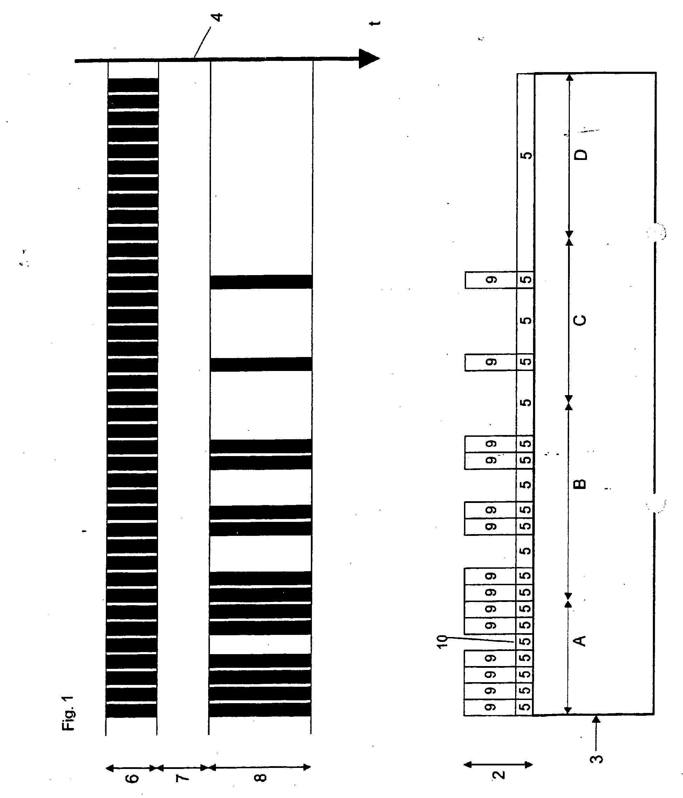

In der Fig. 1 ist schematisch eine Druckplatte 3 im Querschnitt zu erkennen. Die Oberfläche der Druckplatte 3 ist mit einer lichtempfindlichen Schicht 2 beschichtet. Oberhalb der Druckplatte 3 ist in der Figur 1 schematisch der zeitliche Ablauf eines Belichtungsverfahrens gemäß dem Stand der Technik dargestellt. Die horizontale Ausdehnung des Schemas entspricht dabei dem Ort auf der Oberfläche der darunter dargestellten lichtempfindlichen Schicht 2 der Druckplatte 3. In der vertikalen Ausdehnung des Diagramms ist nach unten zunehmend die Zeitachse 4 aufgetragen. Für einen gegebenen Punkt auf der lichtempfindlichen Schicht 2 der Druckplatte 3 ergibt sich daher die Belichtungssequenz durch Betrachten des darüber liegenden Abschnittes in dem Zeitdiagramm. Weiter bedeutet in dem Zeitdiagramm ein dunkler Balken, daß an dieser Stelle zu dem zugehörigen Zeitpunkt eine Belichtung erfolgt. Demgegenüber bedeutet das Fehlen eines dunklen Balkens an einem Ort zu einem gegeben Zeitpunkt bzw. Zeitintervall, dass an diesem Ort zu diesem Zeitpunkt keine Belichtung erfolgt.

In dem Zeitdiagramm der Figur 1 ist nun zu erkennen, dass gemäß dem vorbekannten Belichtungsverfahren zunächst eine unstrukturierte Belichtung mit einer Vorbelichtungsdosis 6 erfolgt. Wie in dem Schema in Fig. 1 zu erkennen, erfolgt die Vorbelichtung 6 unstrukturiert und wirkt auf die gesamte lichtempfindliche Schicht 2 der Druckplatte 3 gleichermaßen. In der lichtempfindlichen Schicht 2 der Druckplatte 3 erzeugt die Belichtung mit der Vorbelichtungsdosis 6 eine durchgehende Schicht von Photopolymerisationsuntergrundpunkten 5. Wie weiter in dem Zeitdiagramm der Fig. 1 zu erkennen, wird anschließend die Belichtung während eines Halteintervalls 7 unterbrochen. Gemäß der Theorie wird damit der in den Photopolymerisationsuntergrundpunkten 5 reversibel gebundene freie Sauerstoff zum Teil wieder freigesetzt.

Als nächstes ist dem Zeitdiagramm zu entnehmen, dass nunmehr eine strukturierte Belichtung gemäß den Bilddaten erfolgt. An den gesetzten Bildpunkten wird durch die strukturierte Belichtungssequenz 8 in der lichtempfindlichen Schicht 2 der Druckplatte 3 jeweils ein Photopolymerisationsbildpunkt 9 erzeugt.

Das nach dem in Fig. 1 veranschaulichten, bekannten Belichtungsverfahren erzeugte Bild ist in vieler Hinsicht qualitativ unzureichend. Zum einen besteht die Gefahr, dass einzelne ungesetzte Bildpunkte 10 in Bereichen A mit großer Flächendichte von Photopolymerisationsbildpunkten 9 ebenfalls unerwünscht durch polymerisieren. Dies wird darauf zurückgeführt, dass sich zwischen den Polymerisationsbildpunkten 9 im Flächendichten-Bereich A Photopolymerisationsuntergrundpunkte 5 befinden, welche durch die Vorbelichtungsdosis 6 erzeugt wurden. Hierdurch ist der ohne Vorbelichtung in der lichtempfindlichen Schicht 2 vorhandene freie Sauerstoff, welcher der Photopolymerisation entgegenwirkt, nicht mehr vorhanden. Infolge wachsen die einzelnen ungesetzten Bildpunkte 10 häufig zusammen. Auf der anderen Seite ist bei dem in Fig. 1 dargestellten bekannten Verfahren nach dem Stand der Technik nachteilig, dass Photopolymerisationsbildpunkten 9 in Bereichen B mittlerer Flächendichte oder in Bereichen C kleiner Flächendichte unerwünscht nicht vollständig durch polymerisieren, da die Photopolymerisationsuntergrundpunkte 5 aufgrund des Halteintervalls 7 bereits wieder so viel freien Sauerstoff enthalten, dass die Photopolymerisation behindert wird. Dieses Problem ist besonders bei Photopolymerisationsbildpunkten 9 in Bereichen C kleiner Flächendichte (sogenannten highlight Bereichen) ausgeprägt. Aufgrund dessen ist ein Erzeugen von Photopolymerisationsbildpunkten 9 in den Bereichen kleiner Flächendichte C häufig gänzlich unmöglich. Schließlich ist eine Belichtung mit der Vorbelichtungsdosis 6 in Bereichen mit verschwindender Flächendichte D ohne Bedeutung für das Endresultat. Die Erzeugung von Photopolymerisationsuntergrundpunkten 5 in den Bereichen D gemäß dem bekannten Verfahren ist daher entbehrlich.

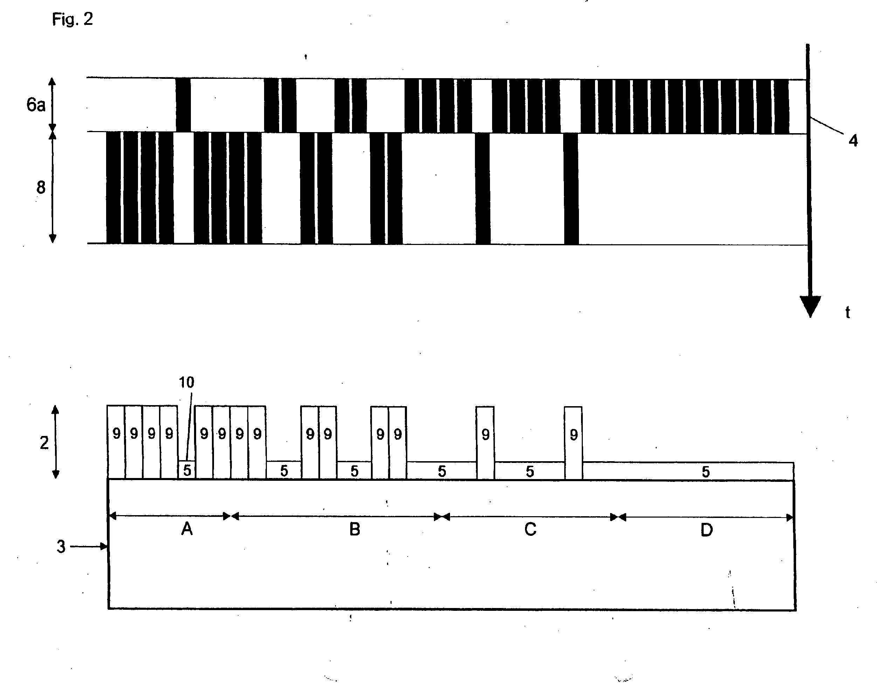

Die Fig. 2 zeigt eine schematische Darstellung, welche der in Fig. 1 gezeigten analog ist. Im Unterschied zur Fig. 1 zeigt die Fig. 2 jedoch ein anderes aus dem Stand der Technik vorbekanntes Verfahren zur strukturierten Belichtung einer Druckplatte 3 mit einer lichtempfindlichen Schicht 2. Wie in dem Zeitdiagramm zu erkennen, erfolgt jedoch anstelle der unstrukturierten Vorbelichtung 6 aus Fig. 1 bei diesem bekannten Verfahren eine Vorbelichtung 6a nur an ungesetzten Bildpunkten. Dies entspricht einer Vorbelichtung mit einem inversen Bild, also mit dem Negativ. Hierdurch wird in der lichtempfindlichen Schicht 2 der Druckplatte 3 eine Schicht von Photopolymerisationsuntergrundpunkten 5 erzeugt, welche sich nur an jenen Orten innerhalb der lichtempfindlichen Schicht 2 ausbildet, an denen keine Photopolymerisationsbildpunkte 9 erzeugt werden sollen.

Im nächsten sich unmittelbar zeitlich anschließenden strukturierten Belichtungsvorgang 8 erfolgt wie bereits in Fig. 1 die Belichtung mit der eigentlichen Bildinformation zur Erzeugung der Photopolymerisationsbildpunkte 9. Auch bei diesem vorbekannten Belichtungsverfahren besteht die Gefahr, dass einzelne ungesetzte Bildpunkte 10 in Bereichen A größter Flächendichte in unerwünschter Weise durchpolymerisieren und so den Tonwertumfang der Druckplatte 3 begrenzen. Ebenfalls erfolgt auch bei dem in Fig. 2 dargestellten bekannten Verfahren eine Belichtung der Bereiche D, in denen sich überhaupt keine zu setzenden Photopolymerisationsbildpunkte befinden, ohne dass dies einen Vorteil bringen würde.

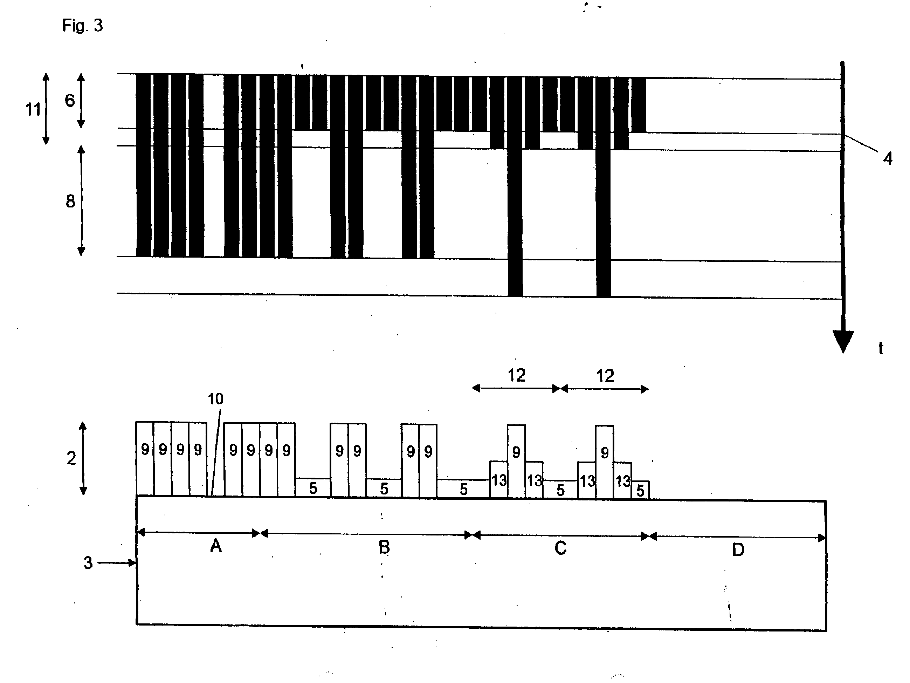

Die Fig. 3 zeigt schließlich in derselben Darstellungsform, welche bereits in den Figuren 1 und 2 gewählt wurde, das Verfahren gemäß der vorliegenden Erfindung. Dem Zeitdiagramm der Fig. 3 entnimmt man, dass bei dem erfindungsgemäßen Verfahren die Belichtung eines jeden Punktes auf der lichtempfindlichen Schicht 2 der Druckplatte 3 in Abhängigkeit von dem Flächendichten-Bereich A, B, C oder D sowie in Abhängigkeit von der Bildinformation, also ob ein Photopolymerisationsbildpunkt 9 zu setzen ist oder nicht, gewählt wird. Insbesondere wird an einzelnen ungesetzten Bildpunkten 10 in Bereichen größter Flächendichte A (shadows) keine Vorbelichtungsdosis 6 aufgebracht. Hierdurch ist es möglich, diese einzelnen ungesetzten Bildpunkte 10 sauber von den Photopolymerisationsbildpunkten 9 zu trennen. Chemisch-physikalisch wird hier der freie Sauerstoff innerhalb der lichtempfindlichen Schicht 2 mit Vorteil zur Unterdrückung des Photopolymerisationsvorgangs ausgenutzt.

Eine weitere Besonderheit bei dem Verfahren gemäß der vorliegenden Erfindung wie es schematisch in der Fig. 3 dargestellt ist, ist die Behandlung einzeln stehender Photopolymerisationsbildpunkte 9 in Bereichen C kleiner Flächendichte (sogenannten highlights). Diese haben wie erläutert einerseits das Problem, dass sie aufgrund der Tatsache, dass sie einzeln stehend sind, zu ihrer vollständigen Photopolymerisation in der Praxis eine erhöhte Dosis zur vollständigen Photopolymerisation der lichtdurchlässigen Schicht sowie dessen Haftung an der Druckplatte 3 benötigen. Bei dem Verfahren gemäß der vorliegenden Erfindung wird diesem Umstand Rechnung getragen, indem Photopolymerisationsbildpunkte 9 in highlight-Bereichen C mit einer verlängerten Belichtungssequenz 11 erzeugt werden. Außerdem werden zur besseren mechanischen Stabilisierung von diesen Photopolymerisationsbildpunkten 9 in den Flächendichten-Bereichen C in einer Umgebung 12 dieses Photopolymerisationsbildpunktes nicht-druckende Strukturverstärkungspunkte 13 erzeugt.

Die Strukturverstärkungspunkte 13 sind dadurch gekennzeichnet, dass die lichtempfindliche Schicht 2 im wesentlichen nicht mehr wasserlöslich ist, dass auf der anderen Seite jedoch der Strukturverstärkungspunkt 13 zwar am Untergrund der Druckplatte 3 anhaftet, nicht jedoch an der Oberfläche Die Strukturverstärkungspunkte 13 wirken somit wie eine Art Kitt zur Verstärkung des einzeln stehenden Photopolymerisationsbildpunktes 9 im Bereich C kleiner Flächendichte.

Demgegenüber werden Photopolymerisationsbildpunkte 9 in Bereichen A mit größter Flächendichte (shadow) und mittlerer Flächendichte B lediglich mit der Standarddosis 8 erzeugt. Die Behandlung der nicht gesetzten Punkte in den Flächendichten-Bereichen A und B unterscheidet sich dadurch, dass in den flächendichten Bereichen B nicht-druckende Photopolymerisationsuntergrundpunkte 5 erzeugt werden, wohingegen diese in den flächendichten Bereichen A wie erläutert nicht erzeugt werden. Schließlich wird in Bereichen D verschwindender Flächendichte, in denen also überhaupt keine Photopolymerisationsbildpunkte 9 vorgesehen sind, die lichtempfindliche Schicht 2 gar nicht belichtet.

Die Fig. 4 zeigt genauer die Verhältnisse, welche nach Anwendung des erfindungsgemäßen Verfahrens auf einen allein stehenden Photopolymerisationspunkt 9, der sich in einem Bereich C kleiner Flächendichte befindet, vorherrschen. In Teil (b) der Figur ist eine Draufsicht auf die lichtempfindliche Schicht 2 der Druckplatte 3 mit einem

Photopolymerisationsbildpunkt 9 zu erkennen, welcher sich in einem Bereich C kleiner Flächendichte befindet und somit allein stehend ist. Weiter ist die Umgebung 12 um den allein stehenden Photopolymerisationsbildpunkt 9 herum zu erkennen. Die Umgebung 12 besteht aus mehreren Strukturverstärkungspunkten 13, welche den allein stehenden Photopolymerisationsbildpunkt 9 mechanisch stützen. Der Teil (a) der Fig. 4 zeigt einen Schnitt entlang der Linie A-A, der durch den allein stehenden Photopolymerisationsbildpunkt 9 verläuft. Zu erkennen ist, dass die Strukturverstärkungspunkte 13 den alleinstehenden Photopolymerisationsbildpunkt 9 an dessen Sockel stützen. Ein Abbrechen des allein stehenden Photopolymerisationsbildpunktes 9 durch mechanische Einwirkung von außen wird somit wirksam unterbunden.

Die Fig. 5 zeigt schematisch in Draufsicht die Oberfläche eines Lichtmodulators 14 mit in Zeilen 15 und Spalten 16 angeordneten lichtmodulierenden Zellen. Besonders geeignet ist gemäß der Erfindung die Verwendung eines DMD-Chips. Es können aber auch transmissive Flüssigkristallmikroanzeigeschips (LCD) oder reflektive Flüssigkristallmatrizen (LCOS) zum Einsatz kommen. Der - Lichtmodulator 14 erlaubt die Durchführung eines Integrating-Digital-Screen-Imaging Verfahrens (IDSI), wobei der Lichtmodulator auf die Druckplatte 3 abgebildet wird. Gleichzeitig befindet sich die Druckplatte 3 in einer Relativbewegung zum Lichtmodulator 14. Bei dem für sich genommen bekannten IDSI Belichtungsverfahren werden die Bilddaten durch die Zeilen 15 des Lichtmodulators 14 gescrollt mit einer Rate, die bewirkt, dass die Abbildung der Bilddaten im wesentlichen stationär relativ zu der Druckplatte 3 während der Bewegung gehalten wird. Der ScrollVorgang lässt sich in Abhängigkeit von der für den jeweiligen Photopolymerisationsbildpunkt 9 auf der Druckplatte 3 vorgesehenen Belichtungssequenz nach einer bestimmten einstellbaren Anzahl der für die Belichtung der Druckplatte genutzten Zellen des Lichtmodulators unterbinden.

Die Zeilen 15 des Lichtmodulators 14 sind funktional in vier jeweils aus einer wählbaren Anzahl von Spalten 16 bestehende Segmente I, II, III und IV aufgeteilt. Bei dieser Art der Verwendung des IDSI Verfahrens mit dem Lichtmodulator 14 verläuft die Zeitachse 4 parallel zu den Zeilen 15. Somit entsprechen die die durch die Anzahl der Spalten 16 bestimmten Breiten der Segmente I bis IV jeweils einem Zeitintervall, währenddessen belichtet wird. Jedes Segment entspricht somit bei gegebenen Scroll-Bedingungen und bei gegebener Lichtquelle einer bestimmten Beleuchtungsdosis. Im Einzelnen entspricht das Vorbelichtungssegment I der Vorbelichtungsdosis 6 aus Fig. 3, welche erforderlich ist, um den in der lichtempfindlichen Schicht 2 enthaltenen Sauerstoff zu binden, ohne dass jedoch eine Photopolymerisation der lichtempfindlichen Schicht 2 erfolgt.

Das Strukturverstärkungssegment II entspricht einer Strukturverstärkungsdosis, welche so gewählt ist, dass sie zusammen mit der erwähnten Vorbelichtungsdosis einen Zustand erzeugt, in welchem die lichtempfindliche Schicht 2 im wesentlichen nicht mehr wasserlöslich ist, aber noch nicht am Untergrund der Druckplatte 3 haftet. Durch eine Belichtung durch das Vorbelichtungssegment I und das Strukturverstärkungssegment II wird ein Strukturverstärkungspunkt 13 erzeugt.

Das Standardbelichtungssegment III entspricht der Belichtung mit einer Standarddosis (vgl. 8 in Fig. 3). Die Standarddosis 8 ist so gewählt, dass sie zusammen mit der Vorbelichtungsdosis 6 und der Strukturverstärkungsdosis in den Bereichen A, B mit größter und mittlerer Flächendichte eine vollständige Photopolymerisation des Photopolymerisationsbildpunktes 9 bewirkt. Schließlich entspricht das highlight-Segment IV der Dosis, welche zusammen mit der Vorbelichtungsdosis, der Strukturverstärkungsdosis und der Standarddosis eine vollständige Polymerisation der alleinstehenden Photopolymerisationsbildpunkte 9 in Bereichen C mit kleinster Flächendichte bewirkt.

Zur Erzeugung eines Photopolymerisationsbildpunktes 9 in einem Bereich C mit kleinster Flächendichte sollten also die Segmente I, II, III und IV auf dem Lichtmodulator 14 in der entsprechenden Zeile 15 aktiviert sein. Dieser Fall ist in Fig. 5 mit dem Bezugszeichen 9, C in der ersten Zeile beschriftet.

Zur Erzeugung eines Photopolymerisationsbildpunktes 9 in Bereichen A bzw. B mit größter bzw. mittlerer Flächendichte genügt demgegenüber die Aktivierung der Segmente I, II sowie III auf dem Lichtmodulator 14, um einen vollständig polymerisierten und an der Druckplatte 3 haftenden Photopolymerisationsbildpunkt 9 zu erzeugen. Dieser Fall ist in Fig. 5 in der Zeile 2 mit den Alternativen 9, B sowie 9, A beschriftet. Insbesondere ist zu erkennen, dass zur Erzeugung dieser Punkte das Segment IV der entsprechenden Zeile inaktiv gesetzt ist.

Weiter ist zur Erzeugung eines Strukturverstärkungspunktes 13 in der Umgebung 12 eines einzeln stehenden Photopolymerisationsbildpunktes 9 in einem Bereich C kleiner Flächendichte die Belichtung mit der Vorbelichtungsdosis 6 sowie der Strukturverstärkungsdosis 11 erforderlich. Zu diesem Zweck werden auf dem Lichtmodulator 14 lediglich die Segmente I und II aktiv geschaltet. Dieser Fall ist in der dritten Zeile des Lichtmodulators 14 aus Fig. 5 mit 13, C beschriftet.

Ferner wird zur Erzeugung von Photopolymerisationsuntergrundpunkten 5 in Bereichen B mittlerer Flächendichte lediglich das Vorbelichtungssegment I aktiv geschaltet. Dieser Fall ist mit dem Bezugszeichen 5 vor der entsprechenden Zeile des Lichtmodulators 14 in Fig. 5 beschriftet.

Schließlich unterbleibt bei der Erzeugung eines einzelnen ungesetzten Bildpunktes 10 in einem Bereich A größter Flächendichte gleichermaßen wie bei einem ungesetzten Bildpunkt in einem Bereich D von verschwindender Flächendichte eine Belichtung komplett. Dementsprechend ist zur Erzeugung dieser Punkte auf dem Lichtmodulator 14 keines der Segmente I bis IV aktiv gesetzt. Dieser Fall ist in der Fig. 5 mit den Alternativen D sowie 10, A beschriftet.

Somit ist durch Verwendung des Integrating-Digital-Screen-Imaging Verfahrens eine überraschend einfache Umsetzung des in Fig. 3 veranschaulichten erfindungsgemäßen Verfahrens zur strukturierten Belichtung von Druckplatten 3 vorgeschlagen, welches eine Belichtung jedes Punktes innerhalb der lichtempfindlichen Schicht 2 der Druckplatte 3 durchführt nach Auswahl eines der Flächendichten-Bereiche A, B, C oder D sowie in Abhängigkeit von der Bildinformation, also ob ein Punkt im Bild zu setzen ist oder nicht.

Die Fig. 6 veranschaulicht schematisch ein Verfahren gemäß der Erfindung zur Ermittlung von Photopolymerisationsbildpunkten 9, die sich in Bereichen C kleiner Flächendichte befinden. In Teil (a) der Figur 6 sind in der linken bzw. rechten Spalte zwei beispielhafte Bildpunktmatrizen 17 dargestellt. Die in der linken Spalte des Teils (a) der Fig. 6 dargestellte Bildinformation entspricht einem 2x2 Pixel großen Bildpunkt, in dessen Umgebung keine weiteren gesetzten Pixel befindlich sind. Somit handelt es sich bei dem im linken Bild der Fig. 6 (a) dargestellten Beispiel um einen einzeln stehenden Photopolymerisationsbildpunkt 9 in einem Bereich C kleiner Flächendichte. Demgegenüber ist in der rechten Spalte des Teils (a) der Fig. 6 eine 3x3 große Anordnung von zu setzenden Bildpunkten dargestellt.

In dem Teil (b) der Figur 6 ist nun jeweils das aus dem in Teil (a) der Figur zu erkennenden Originalbild erzeugte, umgewandelte Bild zu erkennen. Die Umwandlung gemäß der Erfindung betrifft die Eliminierung aller Pixel, die mindestens einen nicht gesetzten Nachbarn haben, wobei dies mit einer logischen UND-Verknüpfung durchgeführt wird. Bei dem in der linken Spalte dargestellten Originalbild führt dies zur Eliminierung sämtlicher Pixel. Demgegenüber verbleibt bei der 3x3 Anordnung von Bildpunkten gemäß dem rechten Bild der zentrale Pixel gesetzt, wird also nicht eliminiert.

Schließlich ist in der Fig. (c) das nach einem weiteren Verarbeitungsschrift gemäß der Erfindung erhaltene Bild zu erkennen. Das in Teil (c) zu erkennende Bild entsteht aus dem in Teil (b) dargestellten, indem alle Pixel gesetzt werden, die mindesten einen gesetzten Nachbarn aufweisen. Diese Operation wird mit einer logischen ODER-Verknüpfung durchgeführt, was mit minimaler Rechenzeit möglich ist. Bei dem linken Bild, ausgehend von der 2x2 Bildstruktur, entsteht hierdurch wie dargestellt eine Struktur ohne gesetzte Pixel. Demgegenüber entsteht in dem rechts dargestellten, vom 3x3 Bild ausgehenden Fall wieder das Ausgangsbild des Teils (a) der Fig. 6.

Wenn nun das Ausgangsbild des Teils (a) der Figur mit dem Bild in Teil (c) der Figur verglichen wird, lässt sich entscheiden, ob ein einzeln stehender Pixel 9 in einem Bereich C kleiner Flächendichte vorliegt oder nicht. Highlight-Pixel sind solche Pixel, welche in dem Bild aus Teil (c) der Figur nicht gesetzt sind, die jedoch im Ausgangsbild (vgl. Teil (a) der Figur 6) gesetzt sind. Dies wird rechentechnisch einfach und sehr effizient erreicht durch eine logische UND- sowie eine logische NICHT-Verknüpfung. Hierdurch ist also ein überraschend rechenzeitoptimiertes Verfahren vorgeschlagen, um einzeln stehende Pixel aus den Bilddaten zu erkennen.

### BEZUGSZEICHENLISTE

- 1: Photopolymerisationsbildpunkt
- 2: lichtempfindliche Schicht
- 3: Druckplatte
- 4: Zeitachse
- 5: Photopolymerisationsuntergrundpunkt
- 6: unstrukturierte Vorbelichtungsdosis
- 6a: inverse Vorbelichtung
- 7: Halteintervall
- 8: strukturierte Belichtung
- 9: Photopolymerisationsbildpunkt
- 10: einzelne ungesetzte Bildpunkte
- 11: Strukturverstärkungsbelichtungssequenz
- 12: Umgebung
- 13: Strukturverstärkungspunkt
- 14: Lichtmodulator
- I: Vorbelichtungssegment
- II: Strukturverstärkungssegment
- III: Standardbelichtungssegment
- IV: highlight Segment
- 15: Zeilen
- 16: Spalten
- 17: Bildpunktmatrix
- A: Bereich größter Flächendichte (shadow)
- B: Bereich mittlerer Flächendichte (main)
- C: Bereich kleiner Flächendichte (highlight)
- D: Bereich von verschwindender Flächendichte

## Patentansprüche

1. Verfahren zur Erzeugung einer Struktur von Photopolymerisationsbildpunkten (9) in der lichtempfindlichen Schicht (2) von Druckplatten (3), insbesondere Flexodruckplatten, als Abbild von aus einer Matrix (17) von Bildpunkten zusammengesetzten Bilddaten mittels strukturierter Belichtung mit einer Lichtquelle, **dadurch gekennzeichnet**,daßjeder Photopolymerisationsbildpunkt (9) durch eine individuelle, in Abhängigkeit von der Flächendichte der zu setzenden Photopolymerisationsbildpunkte (9) am Ort (A, B, C, D) des Photopolymerisationsbildpunktes (9) einerseits und von den Bilddaten andererseits gewählte Belichtungssequenz (6, 8, 11) erzeugt wird, wobei an nicht gesetzten Bildpunkten, welche sich an Orten (B) mit mittlerer Flächendichte befinden, nicht-druckende Photopolymerisationsuntergrundpunkte (5) mit einer Vorbelichtungssequenz (6) erzeugt werden, umfassend den folgenden Schritt:
a. Belichten mit einer Vorbelichtungsdosis zum Binden des in der lichtempfindlichen Schicht (2) enthaltenen Sauerstoffs, wobei die Vorbelichtungsdosis so gewählt ist, daß noch keine Photopolymerisation erfolgt
und wobei an gesetzten Bildpunkten (9) an Orten (A, B) mit mittlerer oder großer Flächendichte druckende Photopolymerisationsbildpunkte (9) mit einer Standardsequenz (8) erzeugt werden, umfassend die Schritte
a. Belichten mit der genannten Vorbelichtungsdosis
b. Belichten mit einer Strukturverstärkungsdosis, wobei die Strukturverstärkungsdosis so gewählt ist, daß sie zusammen mit der Vorbelichtungsdosis einen Zustand erzeugt, in welchem die lichtempfindliche Schicht (2) im wesentlichen nicht mehr wasserlöslich ist, aber noch nicht am Untergrund der Druckplatte (3) haftet.
c. Belichten mit einer Standarddosis, wobei die Standarddosis so gewählt ist, daß sie zusammen mit der Vorbelichtungsdosis und der Strukturverstärkungsdosis an Orten (A) mit größter Flächendichte eine vollständige Photopolymerisation des Photopolymerisationsbildpunktes (9) bewirkt.
und wobei an nicht gesetzten Bildpunkten (10), welche sich an Orten mit großer Flächendichte befinden, keine Belichtung erfolgt

2. Verfahren nach Anspruch 1, **dadurch gekennzeichnet, daß** an nicht gesetzten Bildpunkten in einer Umgebung (12) von Photopolymerisationsbildpunkten (9), welche sich an Orten (C) mit kleiner Flächendichte befinden, mittels einer Strukturverstärkungssequenz (11) nicht-druckende Strukturverstärkungspunkte (13)*(scum)* erzeugt werden, wobei die Strukturverstärkungssequenz (11) die folgenden Schritte umfaßt:
a. Belichten mit der Vorbelichtungsdosis
b. Belichten mit der Strukturverstärkungsdosis

3. Verfahren nach Anspruch 2, **dadurch gekennzeichnet, daß** die Umgebung (12) quadratisch ist.

4. Verfahren nach Anspruch 2 oder 3, **dadurch**
**gekennzeichnet , daß** die Ausdehnung der Umgebung (12) in Abhängigkeit von der Divergenz der Lichtquelle gewählt wird.

5. Verfahren nach einem der Ansprüche 2 bis 4, **dadurch gekennzeichnet, daß** die Ausdehnung der Umgebung (12) in Abhängigkeit von der Dicke der lichtempfindlichen Schicht (2) gewählt wird.

6. Verfahren nach einem der Ansprüche 2 bis 5, **dadurch gekennzeichnet, daß** die Ausdehnung der Umgebung (12) dem Produkt aus der Dicke der lichtempfindlichen Schicht (2) und dem Tangens des Quotienten aus einem Aperturwinkel einer Beleuchtungsoptik und der Pixelgröße entspricht.

7. Verfahren nach einem der vorhergehenden Ansprüche, **dadurch gekennzeichnet, daß** die Strukturverstärkungsdosis etwa 5% der Vorbelichtungsdosis entspricht.

8. Verfahren nach einem der vorhergehenden Ansprüche, **dadurch gekennzeichnet, daß** an gesetzten Bildpunkten an Orten (C) mit kleiner Flächendichte druckende Photopolymerisationsbildpunkte (9) *(highlights)* mit einer Einzelbildpunktsequenz erzeugt werden, umfassend die Schritte:
a. Belichten mit der Vorbelichtungsdosis
b. Belichten mit der Strukturverstärkungsdosis
c. Belichten mit der Standarddosis
d. Belichten mit einer Einzelbildpunktdosis, wobei die Einzelbildpunktdosis so gewählt ist, daß sie zusammen mit der Vorbelichtungsdosis, der Strukturverstärkungsdosis und
der Standarddosis eine vollständige Polymerisation der Photopolymerisationsbildpunkte (9) an Orten (C) mit kleinster Flächendichte bewirkt.

9. Verfahren nach einem der vorhergehenden Ansprüche, **dadurch gekennzeichnet, daß** die Belichtung mittels eines Integrating-Digital-Screen-Imaging Verfahren (IDSI) durchgeführt wird, bei welchem Licht aus der Lichtquelle auf einem Lichtmodulator (14), der eine Mehrzahl von Reihen (13) aus lichtmodulierenden Zellen aufweist, abgebildet wird und von diesem moduliert wird, wonach der Lichtmodulator (14) auf die Druckplatte (3), welche sich in einer Relativbewegung zum Lichtmodulator (14) befindet, abgebildet wird, wobei die Richtung der Bewegung im wesentlichen parallel zu der Richtung der Zeilen (15) aus lichtmodulierenden Zellen verläuft und wobei die Bilddaten durch die Spalten (16) des Lichtmodulators (14) gescrollt werden, mit einer Rate, durch die die Abbildung der Bilddaten im wesentlichen stationär relativ zu der Druckplatte (3) während der Bewegung gehalten wird, wobei, der Scrollvorgang in Abhängigkeit von der für den jeweilige Photopolymerisationsbildpunkt (9) auf der Druckplatte (3) vorgesehenen Belichtungssequenz (6, 8, 11) nach einer bestimmten einstellbaren Anzahl der für die Belichtung der Druckplatte (3) genutzten Zellen des Lichtmodulators (14) unterbunden wird.

10. Verfahren nach Anspruch 9, **dadurch gekennzeichnet, daß** die Bilddaten in eine beliebige Spalte (16) verschoben werden können, um von dort aus zu den nächsten folgenden Spalten (16) übertragen zu werden.

11. Verfahren nach Anspruch 9 oder 10, **dadurch**
**gekennzeichnet, daß** der Lichtmodulator (14) in vier jeweils
aus einer wählbaren Anzahl von Spalten (16) bestehende, bezüglich der Scrollrichtung hintereinander angeordnete Segmente (I, II, II, IV), welche jeweils einer bestimmten Belichtungsdosis entsprechen, aufgeteilt wird.

12. Verfahren nach einem der Ansprüche 9 bis 11, **dadurch gekennzeichnet, daß** die Anzahl der Spalten (16) der Segmente (I, II, III, IV) sich untereinander wie die Beträge der Belichtungsdosen verhalten.

13. Verfahren nach einem der vorhergehenden Ansprüche, **dadurch gekennzeichnet, daß** zur Ermittlung der highlight-Bereiche die Photopolymerisationsbildpunkte (9) an Orten (C) mit kleinster Flächendichte aus den Bilddaten
ermittelt werden, indem ausgehend von dem Originalbild die folgenden Schritte mit dem jeweils im vorhergehenden Schritt erhaltenen Bild durchgeführt werden:
a. Eliminieren aller Pixel, die mindestens einen nicht gesetzten Nachbarn haben, vorzugsweise umfassend eine logische UND-Verknüpfung,
b. Setzen aller Pixel, die mindestens einen gesetzten Nachbarn aufweisen, vorzugsweise umfassend eine logische ODER-Verknüpfung,
c. Setzen der Pixel, die in dem durch Schritt b erhaltenen Bild nicht gesetzt sind und gleichzeitig im Ausgangsbild gesetzt sind, vorzugsweise umfassend eine logische UND- sowie eine logische NICHT-Verknüpfung.

14. Verfahren nach Anspruch 13,
**dadurch gekennzeichnet, daß** zur Ermittlung der scum Bereiche die Umgebung von
Photopolymerisationsbildpunkten (9) an Orten (C) mit kleinster Flächendichte, wie folgt aus den Bilddaten ermittelt wird:
a. Setzen von Pixeln, die mindestens einen benachbarten Polymerisationsbildpunkt an einem Ort (C) mit kleinster Flächendichte aufweisen, vorzugsweise umfassend eine ODER-Verknüpfung

15. Verfahren nach einem der vorhergehenden Ansprüche
, **dadurch gekennzeichnet, daß** zum Ermitteln von nicht-druckenden Photopolymerisationsuntergrundpunkten (5) wie folgt vorgegangen wird, wobei ausgehend von dem Originalbild die folgenden Schritte mit dem jeweils im vorhergehenden Schritt erhaltenen Bild durchgeführt werden:
a. Setzen aller Pixel, die mindestens einen gesetzten Nachbarn haben, vorzugsweise umfassend eine logische ODER-Verknüpfung
b. Löschen aller Pixel, die mindestens einen nicht-gesetzten Nachbarn haben
c. Setzen aller Pixel, die Teil des in Schritt b erhaltenen Bildes, nicht aber Teil des Ausgangsbildes sind
d. Invertieren des in Schritt c erhaltenen Bildes.

16. Verfahren nach Anspruch 14 und 15, **dadurch gekennzeichnet, daß** zum Ermitteln von nicht-druckenden Photopolymerisationsuntergrundpunkten (5) das in Schritt d aus Anspruch 15 erhaltene Bild mit dem in Anspruch 14 erhaltenen Bild durch eine logische ODER-Operation verknüpft wird.

17. Verfahren nach Anspruch 14 und 15, **dadurch**
**gekennzeichnet , daß** zum Ermitteln von nicht-druckenden Photopolymerisationsuntergrundpunkten (5) das in Schritt d aus Anspruch 15 erhaltene Bild mit dem in Anspruch 14 erhaltenen Bild durch eine logische UND-Operation verknüpft wird.

18. Verfahren nach einem der vorhergehenden Ansprüche, **dadurch gekennzeichnet, daß** an nicht-gesetzten Bildpunkten an Orten (D) mit verschwindender Flächendichte keine Belichtung erfolgt.

19. Verfahren nach einem der Ansprüche 9 bis 12, **dadurch gekennzeichnet, daß** die Anzahl der Spalten (16) der Segmente (I, II, III, IV) unter Berücksichtigung einer der jeweiligen Spalte entsprechenden, ortsabhängigen Ausleuchtungsintensität des Lichtmodulators gewählt wird.

## Claims

1. Method for producing a structure of photopolymerisation picture points (9) in the light-sensitive layer (2) of printing plates (3), in particular flexo-printing plates, as an image of picture data composed of a matrix (17) of picture points, by means of structured exposure with a light source, **characterised in that** each photopolymerisation picture point (9) is produced by an individual exposure sequence (6, 8, 11) selected depending, on the one hand, on the surface density of the photopolymerisation picture points (9) to be set at the location (A, B, C, D) of the photopolymerisation picture point (9) and, on the other hand, on the picture data, wherein at non-set picture points which are located at locations (B) having medium surface density, non-printing photopolymerisation subsurface points (5) are produced using a preliminary exposure sequence (6), comprising the following step:
a. exposure with a preliminary exposure dose, for bonding the oxygen contained in the light-sensitive layer (2), wherein the preliminary exposure dose is selected such that photopolymerisation is still not yet effected,
and wherein at set picture points (9) at locations (A, B) having medium or large surface density, printing photopolymerisation picture points (9) are produced using a standard sequence (8), comprising the following steps:
a. exposure with the mentioned preliminary exposure dose
b. exposure with a structure intensification dose, wherein the structure intensification dose is selected such that together with the preliminary exposure dose, it produces a condition in which the light-sensitive layer (2) is basically no longer water-soluble, but yet still adheres to the subsurface of the printing plate (3).
c. exposure with a standard dose, wherein the standard dose is selected such that together with the preliminary exposure dose and the structure intensification dose at locations (A) having the greatest surface density, it effects complete photopolymerisation of the photopolymerisation picture point (9),
and wherein no exposure is effected at non-set picture points (10) which are located at locations having a large surface density.

2. Method according to claim 1, **characterised in that** non-printing structure intensification points (13) (scum) are produced by means of a structure intensification sequence (11) at non-set picture points in an environment (12) of photopolymerisation picture points (9) which are located at locations (C) having a small surface density, wherein the structure intensification sequence (11) comprises the following steps:
a. exposure with a preliminary exposure dose
b. exposure with a structure intensification dose.

3. Method according to claim 2, **characterised in that** the environment (12) is square.

4. Method according to either claim 2 or claim 3, **characterised in that** the extension of the environment (12) is selected depending on the divergence of the light source.

5. Method according to any of claims 2 to 4, **characterised in that** the extension of the environment (12) is selected depending on the thickness of the light-sensitive layer (2).

6. Method according to any of claims 2 to 5, **characterised in that** the extension of the environment (12) corresponds to the product of the thickness of the light-sensitive layer (2) and the tangent of the quotient of an aperture angle of illumination optics and the pixel size.

7. Method according to any of the preceding claims, **characterised in that** the structure intensification dose corresponds to approximately 5 % of the preliminary exposure dose.

8. Method according to any of the preceding claims, **characterised in that** printing photopolymerisation picture points (9) (highlights) are produced using an individual picture point sequence at set picture points at locations (C) having a small surface density, comprising the steps:
a. exposure with the preliminary exposure dose
b. exposure with the structure intensification dose
c. exposure with the standard dose
d. exposure with an individual picture point dose, wherein the individual picture point dose is selected such that together with the preliminary exposure dose, the structure intensification dose and the standard dose, it produces complete polymerisation of the photopolymerisation picture points (9) at locations (C) having the smallest surface density.

9. Method according to any of the preceding claims, **characterised in that** the exposure is carried out by means of an integrating digital screen imaging method (IDSI), in which light from the light source is imaged on a light modulator (14) which comprises a plurality of rows (13) of light-modulating cells, and is modulated by this, whereupon the light modulator (14) is imaged onto the printing plate (3) which is performing a movement relative to the light modulator (14), wherein the direction of the movement runs substantially parallel to the direction of the lines (15) of light-modulating cells, and wherein the picture data is scrolled through the columns (16) of the light modulator (14) at a rate at which the image of the picture data is held substantially stationary relative to the printing plate (3) during the movement, wherein the scrolling procedure is stopped depending on the exposure sequence (6, 8, 11) provided for the respective photopolymerisation picture point (9) on the printing plate (3) after a certain settable number of cells of the light modulator (14) used for the exposure of the printing plate (3).

10. Method according to claim 9, **characterised in that** the picture data may be shifted into any column (16), from where it is transmitted to the next following columns (16).

11. Method according to either claim 9 or claim 10, **characterised in that** the light modulator (14) is divided into four segments (I, II, III, IV) which consist in each case of a selectable number of columns (16), are arranged one after the other in the scrolling direction, and in each case correspond to a certain exposure dose.

12. Method according to any of claims 9 to 11, **characterised in that** the number of columns (16) of the segments (I, II, III, IV) behave amongst one another as the contributions of the exposure doses.

13. Method according to any of the preceding claims, **characterised in that**, to evaluate the highlight regions, the photopolymerisation picture points (9) at locations (C) having the smallest surface density are determined from the picture data, **in that**, proceeding from the original picture, the following steps are carried out with the picture contained in each case in the preceding step:
a. eliminating all pixels which have at least one non-set neighbour, preferably comprising a logic AND link,
b. setting all pixels which comprise at least one set neighbour, preferably comprising a logic OR link,
c. setting the pixels which are not set in the picture obtained by step b and simultaneously set in the original picture, preferably having a logic AND and a logic NOT-link.

14. Method according to claim 13, **characterised in that**, to determine the scum regions, the environment of the photopolymerisation picture points (9) at locations (C) having the smallest surface density is determined from the picture data as follows:
a. setting pixels which have at least one adjacent polymerisation picture point at a location (C) having the smallest surface density, preferably comprising an OR link.

15. Method according to any of the preceding claims, **characterised in that** in order to determine non-printing photopolymerisation subsurface points (5) the following process is carried out wherein, proceeding from the original picture, the following steps are carried out with the respective picture obtained in the preceding step:
a. setting all pixels which have at least one set neighbour, preferably comprising a logic OR link
b. deleting all pixels which have at least one non-set neighbour
c. setting all pixels which are part of the picture obtained in step b, but not part of the original picture
d. inverting the picture obtained in step c.

16. Method according to claim 14 and claim 15, **characterised in that** in order to determine non-printing photopolymerisation subsurface points (5), the picture obtained in step d from claim 15 is linked to the picture obtained in claim 14 by means of a logic OR operation.

17. Method according to claim 14 and claim 15, **characterised in that** in order to determine non-printing photopolymerisation subsurface points (5), the picture obtained in step d from claim 15 is linked to the picture obtained in claim 14 by means of a logic AND operation.

18. Method according to any of the preceding claims, **characterised in that** no exposure is effected at non-set picture points at locations (D) having a disappearing surface density.

19. Method according to any of claims 9 to 12, **characterised in that** the number of columns (16) of the segments (I, II, III, IV) is selected while taking into account a position-dependent illumination intensity of the light modulator, said intensity corresponding to the respective column.

## Revendications

1. Procédé de génération d'une structure de points d'image de photopolymérisation (9) dans la couche photosensible (2) de planches d'impression (3), en particulier de planches d'impression flexographique, sous forme de reproduction de données d'image composées d'une matrice (17) de points d'image, au moyen d'une exposition structurée à l'aide d'une source de lumière, **caractérisé en ce que** chaque point d'image de photopolymérisation (9) est produit par une séquence d'exposition (6, 8, 11) individuelle, choisie d'une part en fonction de la densité superficielle des points d'image de photopolymérisation (9) à définir à l'emplacement (A, B, C, D) du point d'image de photopolymérisation (9), et d'autre part en fonction des données d'image, dans lequel, au niveau de points d'image non définis qui se trouvent à des emplacements (B) de densité superficielle moyenne, des points de fond de photopolymérisation (5) non imprimables sont produits par une séquence de prélumination (6), comprenant l'étape suivante :
a. exposition avec une dose de prélumination pour lier l'oxygène contenu dans la couche photosensible (2), dans lequel la dose de prélumination est choisie de telle sorte qu'aucune photopolymérisation n'a lieu encore,
et dans lequel, des points d'image de photopolymérisation (9) imprimables, définis au niveau de points d'image (9) à des emplacements (A, B) de densité superficielle moyenne ou élevée sont produits par une séquence standard (8), comprenant les étapes :
a. exposition avec ladite dose de prélumination ;
b. exposition avec une dose d'intensification de structure, la dose d'intensification de structure étant choisie de telle sorte qu'en conjonction avec la dose de prélumination, elle produit un état dans lequel la couche photosensible (2) n'est substantiellement plus soluble dans l'eau mais n'adhère pas encore au fond de la planche d'impression (3) ;
c. exposition avec une dose standard, la dose standard étant choisie de telle sorte qu'en conjonction avec la dose de prélumination et la dose d'intensification de structure, elle provoque à des emplacements (A) de la plus grande densité superficielle une photopolymérisation complète du point d'image de photopolymérisation (9),
et dans lequel, aucune exposition n'a lieu au niveau de points d'image (10) non définis qui se trouvent à des emplacements de densité superficielle élevée.

2. Procédé selon la revendication 1, **caractérisé en ce que** des points d'intensification de structure (13) non imprimants (« scum ») sont produits au moyen d'une séquence d'intensification de structure (11) au niveau de points d'image non définis dans un environnement (12) de points d'image de photopolymérisation (9) qui se trouvent à des emplacements (C) de faible densité superficielle, dans lequel la séquence d'intensification de structure (11) comprend les étapes suivantes :
a. exposition avec la dose de prélumination ;
b. exposition avec la dose d'intensification de structure.

3. Procédé selon la revendication 2, **caractérisé en ce que** l'environnement (12) est carré.

4. Procédé selon les revendications 2 ou 3, **caractérisé en ce que** l'étendue de l'environnement (12) est choisie en fonction de la divergence de la source de lumière.

5. Procédé selon l'une quelconque des revendications 2 à 4, **caractérisé en ce que** l'étendue de l'environnement (12) est choisie en fonction de l'épaisseur de la couche photosensible (2).

6. Procédé selon l'une quelconque des revendications 2 à 5, **caractérisé en ce que** l'étendue de l'environnement (12) correspond au produit de l'épaisseur de la couche photosensible (2) et de la tangente du quotient d'un angle d'ouverture d'un système optique d'éclairage et de la taille de pixel.

7. Procédé selon l'une quelconque des revendications précédentes, **caractérisé en ce que** la dose d'intensification de structure correspond à environ 5 % de la dose de prélumination.

8. Procédé selon l'une quelconque des revendications précédentes, **caractérisé en ce que** des points d'image de photopolymérisation (9) imprimables (« highlights »), définis au niveau de points d'image à des emplacements (C) de faible densité superficielle, sont produits par une séquence de points d'image individuels, comprenant les étapes :
a. exposition avec la dose de prélumination ;
b. exposition avec la dose d'intensification de structure ;
c. exposition avec la dose standard ;
d. exposition avec une dose de point d'image individuel, la dose de point d'image individuel étant choisie de telle sorte qu'en conjonction avec la dose de prélumination, la dose d'intensification de structure et la dose standard, elle provoque une polymérisation complète des points d'image de photopolymérisation (9) à des emplacements (C) de la plus faible densité superficielle.

9. Procédé selon l'une quelconque des revendications précédentes, **caractérisé en ce que** l'exposition est effectuée au moyen d'un procédé IDSI (« Integrating Digital Screen Imaging »), dans lequel la lumière provenant de la source de lumière est reproduite sur un modulateur de lumière (14) présentant une pluralité de rangées (13) composées de cellules de modulation de lumière et est modulée par celui-ci, et par la suite, le modulateur de lumière (14) est reproduit sur la planche d'impression (3) qui se trouve dans un mouvement relatif par rapport au modulateur de lumière (14), dans lequel la direction du mouvement s'étend substantiellement en parallèle à la direction des lignes (15) composées de cellules de modulation de lumière, et dans lequel les données d'image passent par les colonnes (16) du modulateur de lumière (14) à une vitesse permettant de maintenir la reproduction des données d'image substantiellement stationnaire par rapport à la planche d'impression (3) pendant le mouvement, dans lequel l'opération de passage est inhibée en fonction de la séquence d'exposition (6, 8, 11) prévue pour le point d'image de photopolymérisation (9) respectif sur la planche d'impression (3) après un certain nombre réglable des cellules du modulateur de lumière (14) utilisées pour l'exposition de la planche d'impression (3).

10. Procédé selon la revendication 9, **caractérisé en ce que** les données d'image peuvent être déplacées dans une colonne (16) quelconque afin de pouvoir être transférées de cet endroit aux colonnes (16) consécutives suivantes.

11. Procédé selon la revendication 9 ou 10, **caractérisé en ce que** le modulateur de lumière (14) est divisé en quatre segments (I, II, III, IV) respectivement composés d'un nombre sélectionnable de colonnes (16) et disposés les uns après les autres par rapport à la direction de passage et qui correspondent respectivement à une certaine dose d'exposition.

12. Procédé selon l'une quelconque des revendications 9 à 11, **caractérisé en ce que** le nombre des colonnes (16) des segments (I, II, III, IV) se comporte les uns par rapport aux autres comme les valeurs des doses d'exposition.

13. Procédé selon l'une quelconque des revendications précédentes, **caractérisé en ce que** pour déterminer les zones dites « highlights », on détermine les points d'image de photopolymérisation (9) à des emplacements (C) de la plus faible densité superficielle à partir des données d'image en effectuant les étapes suivantes sur l'image obtenue respectivement à l'étape précédente, en partant de l'image d'origine :
a. élimination de tous les pixels qui ont au moins un voisin non défini, comprenant de préférence une association ET logique ;
b. définition de tous les pixels qui présentent au moins un voisin défini, comprenant de préférence une association OU logique ;
c. définition des pixels qui ne sont pas définis sur l'image obtenue à l'étape b et qui sont en même temps définis sur l'image de départ, comprenant de préférence une fonction ET logique et une fonction OU logique.

14. Procédé selon la revendication 13, **caractérisé en ce que** pour déterminer les zones dites « scum », l'environnement de points d'image de photopolymérisation (9) est déterminé à des emplacements (C) de la plus faible densité superficielle de la manière suivante à partir des données d'image :
a. définition de pixels présentant au moins un point d'image de polymérisation voisin à un emplacement (C) de la plus petite densité superficielle, comprenant de préférence une association OU.

15. Procédé selon l'une quelconque des revendications précédentes, **caractérisé en ce que** pour déterminer des points de fond de photopolymérisation (5) non imprimables, on procède comme suit, dans lequel, en partant de l'image d'origine, les étapes suivantes sont effectuées sur l'image respectivement obtenue à l'étape précédente :
a. définition de tous les pixels présentant au moins un voisin défini, comprenant de préférence une association OU logique ;
b. suppression de tous les pixels présentant au moins un voisin non défini ;
c. définition de tous les pixels faisant partie de l'image obtenue à l'étape b mais ne faisant pas partie de l'image de départ ;
d. inversion de l'image obtenue à l'étape c.

16. Procédé selon la revendication 14 et 15, **caractérisé en ce que** pour déterminer des points de fond de photopolymérisation (5) non imprimables, l'image obtenue à l'étape d de la revendication 15, est associée à l'image obtenue à la revendication 14 par une opération OU logique.

17. Procédé selon les revendications 14 et 15, **caractérisé en ce que** pour déterminer des points de fond de photopolymérisation (5) non imprimables, l'image obtenue à l'étape d de la revendication 15 est associée à l'image obtenue à la revendication 14 par une opération ET logique.

18. Procédé selon l'une quelconque des revendications précédentes, **caractérisé en ce qu'**aucune exposition n'a lieu au niveau de points d'image non définis à des emplacements (D) de densité superficielle infiniment faible.

19. Procédé selon l'une quelconque des revendications 9 à 12, **caractérisé en ce que** le nombre des colonnes (16) des segments (I, II, III, IV) est choisi en tenant compte d'une intensité d'éclairage du modulateur de lumière, dépendante de l'emplacement et correspondant à la colonne respective.
